# EUROPÄISCHE PATENTSCHRIFT

(11) **EP 3 171 136 B1**
(45) Veröffentlichungstag und Bekanntmachung des Hinweises auf die Patenterteilung: **18.04.2018**
(21) Anmeldenummer: 15195170.4
(22) Anmeldetag: 18.11.2015
(51) Int. Cl.: G01D 5/14, H03K 17/97, G01D 5/244, H01H 36/00

(54) **WIPPSCHALTVORRICHTUNG**
WIPER SWITCHING DEVICE
DISPOSITIF DE CIRCUIT DE BASCULE

(43) Veröffentlichungstag der Anmeldung: 24.05.2017
(73) Patentinhaber: MOBA Mobile Automation AG, 65555 Limburg (DE)
(72) Erfinder: SCHÖNBACH, Torsten, 65555 Limburg (DE)
(74) Vertreter: Zimmermann, Tankred Klaus

(56) Entgegenhaltungen:
- DE-A1- 10 123 625
- DE-A1-102012 204 634
- US-B1- 8 570 126

## Beschreibung

Ausführungsbeispiele der vorliegenden Erfindung beziehen sich auf eine Wippschaltvorrichtung, auf eine Steuer- und Bedieneinheit sowie auf ein Verfahren zum Betreiben einer Wippschaltvorrichtung. Im Allgemeinen liegt der Erfindungskontext auf dem Gebiet von Steuer- und Bedieneinheiten von Hubarbeitsbühnen, mobilen Arbeitsmaschinen oder Baumaschinen mit mindestens einer Wippschaltvorrichtung.

Wippschaltvorrichtungen sind beispielsweise aus der WO 2002/13387 A1 bekannt. Bei einer Wippschaltvorrichtung handelt es sich um eine auf einer Platte befestigte Wippe mit integrierten Dauermagneten, welche bei einer Bewegung des Wippschalters mit bewegt werden. Unterhalb der Platte kann ein magnetoresistives Element zum Detektieren eines Schaltvorgangs angeordnet sein. Alternativ zu den magnetoresistiven Elementen kann ein Hall-Sensor zur Detektion des Magnetfeldes verwendet werden. Der allgemein als Magnetfeldsensor bezeichnete Sensor registriert eine Magnetfeldänderung des Magnetfeldes, erzeugt durch den oder die Dauermagneten, so dass ausgehend von der Magnetfeldänderung eine Betätigung des Wippschalters detektiert werden kann.

Des Weiteren sei auch noch auf US 4,868,530 verwiesen, die eine Wippschaltvorrichtung mit in dem Wippschalter integrierten Dauermagneten zeigt, welche bei einer Bewegung des Wippschalters mit bewegt werden, so dass zwei Magnetsensoren die Bewegung überwachen. Zur Überwachung wird beispielsweise ein Auswerteverfahren eingesetzt. Aus US 8,570,126 ist eine Wippschaltvorrichtung bekannt, die sich durch zwei in den Schalter integrierte Magneten auszeichnet, wobei die Position des Schalters anhand des Abstands zu zwei jeweils den Magneten gegenüberliegenden Magnetfeldsensoren bestimmt wird. Bei den üblichen Auswerteverfahren werden die absoluten Signale eines Wippschalters herangezogen. In den meisten Fällen werden Schaltschwellen auf absolute Werte festgelegt. Falls ein Differenzsignal vorhanden ist, wird auch hier eine konstante Schaltschwelle festgelegt. Diese Schaltschwelle kann in manchen Fällen über den Temperaturwert korrigiert werden.

Nachteilig dabei ist, dass durch unterschiedlichste Toleranzen (Aufbau der Mechanik, unterschiedliche Magnetisierung, Temperaturschwankungen etc.) die Signale eines Wippschalters streuen. Mittels Kalibrierung oder durch grob angenäherte Werte können die Schaltschwellen für einen Wippschalter festgelegt werden. Eine Kalibrierung ist aufwendig und teuer und lässt ein Austauschen von Komponenten nicht zu. Bei den grob angenäherten Werten legt die Schaltschwelle aus Sicherheitsgründen meist weit entfernt von den notwendigen Schaltschwellen. Durch ein Fremdfeld lassen sich die Signale so beeinflussen, dass diese ein Schaltsignal erzeugen.

Bei den bisherigen Lösungsansätzen erzeugt eine Differenzauswertung von zwei abhängigen Signalen ein Schaltsignal, welches unabhängig von einem "homogenen" Störfeld ist. Die Schaltfunktion ist weiterhin gegeben und es wird "nicht" angezeigt, dass ein Störfeld vorhanden ist. Deshalb besteht der Bedarf nach einem verbesserten Ansatz.

Aufgabe der vorliegenden Erfindung ist es, ein Konzept für einen Wippschalter zu schaffen, das eine erhöhte Störunempfindlichkeit aufweist.

Die Aufgabe wird durch den Gegenstand der unabhängigen Patentansprüche gelöst.

Ausführungsbeispiele schaffen eine Wippschaltvorrichtung mit einem Gehäuse, einem an dem Gehäuse befestigten Betätigungselement (Wippe), einer Grundplatte und einer Auswerteeinheit. Das Gehäuse ist dabei an der Grundplatte befestigt. Das Betätigungselement ist relativ gegenüber dem Gehäuse um zumindest eine Drehachse (Drehachse der Wippe) bewegbar und weist zumindest zwei Magnete (z.B. auf der einen Seite der Wippe und auf der anderen Seite der Wippe) auf. An oder in der Grundplatte sind zumindest zwei dem Magneten gegenüberliegende Magnetfeldsensoren, wie z.B. Halleffektsensoren, ortsfest gekoppelt, die jeweils in Abhängigkeit eines Abstands zwischen dem jeweiligen Magnetfeldsensor und dem zugehörigen Magneten ein Sensorsignal ausgeben. Jedes Sensorsignal gibt also Auskunft über eine Endposition oder allgemein einen Abstand, der sich zwischen dem jeweiligen Magneten und dem zugehörigen Magnetfeldsensor aufgrund der Position der Wippe einstellt. Die Auswerteeinheit ist ausgebildet, um ein Kombinationssignal (z.B. ein Multiplikationssignal oder ein zweidimensionales Signal umfassend je Position ein Wertepaar mit dem ersten Sensorsignal als ersten Wert und dem zweiten Sensorsignal als zweiten Wert) der zwei Sensorsignale auszuwerten, um ausgehend von dem Kombinationssignal eine Position und/oder eine Bewegung des Betätigungselements zu ermitteln.

Ausführungsbeispielen der vorliegenden Erfindung liegt also die Erkenntnis zugrunde, dass die Auswertung der Sensorsignale eines Wippschalters, der beispielsweise zwei Halleffektsensoren oder allgemein zwei Magnetfeldsensoren umfasst, besonders störunempfindlich gestaltet werden kann, indem das Kombinationssignal bzw. eine Kombination der Signale der beiden Magnetfeldsensoren ausgewertet wird. Im Detail wird z.B. durch die Auswerteeinheit (Steuerung) aus den beiden Sensorsignalen eine Funktion (Kombinationssignal) gebildet, welches von der Position des Wippschalters entlang dem Bewegungsbereich des Wippschalters (Relativposition zwischen Wippschalter und dem zugehörigen Gehäuse) abhängig ist. Dadurch dass hier nicht nur ein Sensorsignal je halber Bewegungsbereich, sondern beide Sensorsignale für den gesamten Bewegungsbereich ausgewertet werden, ist diese Auswertung besonders robust und deshalb störunanfällig.

Entsprechend bevorzugten Ausführungsbeispielen sind Magnet und zugehörige Magnetfeldsensoren auf unterschiedlichen Seiten in Bezug auf die Drehachse angeordnet, so dass bei einer Bewegung der Wippe in eine Richtung ein Abstand zwischen Magnet und zugehörigem Magnetfeldsensor reduziert wird (infolgedessen beispielsweise das entsprechende Sensorsignal steigt), während sich gleichzeitig ein Abstand zwischen dem anderen Magneten und dem anderen Magnetfeldsensor vergrößert (wobei das entsprechende Sensorsignal sich verkleinert). Dadurch dass beide Sensorsignale entsprechend Ausführungsbeispielen nicht-linear sind, hat auch das Kombinationssignal einen nicht-linearen Verlauf über den gesamten Bewegungsbereich des Betätigungselements. Diese Nichtlinearität verbessert auch die Auswertbarkeit, da sichergestellt werden kann, dass sich die zwei Werte des Wertepaares (Kombinationssignals) unterschiedlich verändern, so dass beispielsweise das eine Signal mit zunehmender Bewegung des Wippelements langsam anwächst, während das andere Signal schnell anwächst. Dies hat den Vorteil, dass so klar und eindeutig erkennbar ist, dass es sich um eine Bewegung der Wippe handelt und nicht um eine Störung, wie z.B. ein extern anliegendes Magnetfeld, das typischerweise in beiden Magnetfeldsensoren eine vergleichbare Veränderung der jeweiligen Sensorsignale bewirkt.

Also kann entsprechend Ausführungsbeispielen ein sogenannter Gültigkeitswertebereich vorab bestimmt sein. Dieser Gültigkeitswertebereich repräsentiert einen normalen Arbeitsbereich der zwei Sensorelemente. Infolgedessen ist die Auswerteeinheit dazu ausgebildet, auf Basis des Kombinationssignals eine Position und/oder eine Bewegung des Betätigungselements dann zu bestimmen, wenn das Kombinationssignal innerhalb des Gültigkeitsbereichs liegt. Entsprechend Ausführungsbeispielen kann der Gültigkeitsbereich durch eine Hüllkurve, die einen Signalverlauf des Kombinationssignals über dem Bewegungsbereich des Betätigungselements relativ zu dem Gehäuse einhüllt, definiert sein. Die Hüllkurve bietet den Vorteil, dass nicht für jeden hergestellten Wippschalter ein neuer Gültigkeitswertebereich definiert werden muss, da die Hüllkurve so gewählt sein kann, dass Fertigungstoleranzen oder Toleranzen aufgrund von mechanischen Veränderungen des Wippschalters (Verschleiß oder Temperaturänderung) in dem Gültigkeitswertebereich mit berücksichtigt sind. Entsprechend weiteren Ausführungsbeispielen kann die Auswerteeinheit dazu ausgebildet sein, einen Fehler, wie z.B. einen Defekt der Sensorelemente oder einen mechanischen Defekt oder ein extern vorliegendes Magnetfeld oder eine Überschreitung des Temperaturbereichs anhand dessen zu detektieren, dass das Kombinationssignal außerhalb dem Gültigkeitswertebereich liegt.

Entsprechend bevorzugten Ausführungsbeispielen wird die Hüllkurve durch Veränderung der Funktionsparameter gewonnen, wobei die Hüllkurve so gewählt wird, dass innerhalb dieser Hüllkurve die Signale zulässig sind. Sobald die Signale diese Hüllkurve verlassen, liegt ein Fehler vor oder ist ein Störfeld, beispielsweise ein magnetisches Störfeld vorhanden.

Entsprechend zusätzlichen Ausführungsbeispielen kann anstelle eines zweidimensionalen Wippschalters (z.B. eines Wippschalters für "Hoch/Runter") ein dreidimensionaler Wippschalter, z.B. mit den Bewegungsrichtungen "Hoch/Runter" und "Links/Rechts" vorgesehen sein.

Weitere Ausführungsbeispiele beziehen sich auf eine Steuer- und Bedieneinheit für eine Hubarbeitsbühne, eine mobile Arbeitsmaschine oder eine Baumaschine mit einer Wippschaltvorrichtung, wie sie oben erläutert wurde.

Des Weiteren schafft ein zusätzliches Ausführungsbeispiel ein Verfahren zum Betreiben bzw. zum Auswerten einer Wippschaltvorrichtung. Das Verfahren hat den einen Basisschritt "Auswerten eines Kombinationssignals der zwei Sensorsignale", um ausgehend von dem Kombinationssignal eine Position und/oder eine Bewegung des Betätigungselements zu ermitteln.

Weiterbildungen sind in den Unteransprüchen definiert. Ausführungsbeispiele der vorliegenden Erfindung werden anhand der beiliegenden Zeichnungen erläutert. Es zeigen:
- Fig. 1: eine schematische Darstellung einer Wippschaltvorrichtung gemäß einem Ausführungsbeispiel;
- Fig. 2a-2c: schematische Diagramme zur Illustration der Sensorsignale die einzelnen Magnetfeldsensoren und des Kombinationssignals entsprechend Ausführungsbeispielen;
- Fig. 2d: ein schematisches Diagramm des Kombinationssignals in Verbindung mit einer Hüllkurve als Gültigkeitswertebereich entsprechend Ausführungsbeispielen;
- Fig. 3a-3c: Messtechnisch ermittelte Diagramme zur Illustration des Kombinationssignals mit zugehöriger Hüllkurve zur Illustration von unterschiedlichen Betriebszustände gemäß Ausführungsbeispielen; und
- Fig. 4: eine schematische Expositionsdarstellung eines Wippschalters zur Darstellung von dessen Innenaufbau.

Bevor nachfolgend Ausführungsbeispiele der vorliegenden Erfindung anhand der beiliegenden Zeichnungen erläutert werden, sei darauf hingewiesen, dass gleiche Elemente und Strukturen mit gleichen Bezugszeichen versehen sind, so dass die Beschreibung derer aufeinander anwendbar bzw. austauschbar ist.

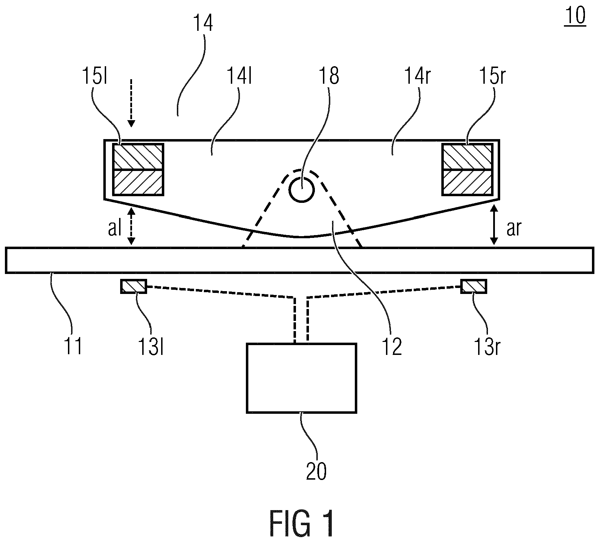

Fig. 1 zeigt einen Wippschalter 10 umfassend ein Gehäuse 12 sowie die Wippe 14 als Betätigungselement, welche relativ gegenüber dem Gehäuse 12 um die Drehachse 18 bewegbar ist. Die Wippe umfasst in diesem Ausführungsbeispiel zwei Hälften 14l und 14r, welche sich diesseits und jenseits der Drehachse 18 erstrecken. Das Gehäuse 12 ist beispielsweise lösbar an einer Grund- bzw. Frontplatte 11 befestigt.

Sowohl auf der Seite 14l als auch auf der Seite 14r ist jeweils ein Magnet 15l und 15r angeordnet, so dass also das Betätigungselement insgesamt zwei Magnete 15l und 15r umfasst. Das Gehäuse 12 umfasst bzw. in, auf oder bevorzugt unter dem Gehäuse 12 oder sogar unter der Grundplatte 11 sind zwei Magnetfeldsensoren, wie z.B. Halleffektsensoren, 13l und 13r in der Art angeordnet. Allgemein ausgedrückt sind die Magnetfeldsensoren 13l und 13r ortsfest gegenüber dem Gehäuse 12 bzw. ortsfest gegenüber der Grundplatte 11 derart gekoppelt, dass die Magnetfeldsensoren 13l und 13r den Magneten 15l und 15r gegenüberliegen, d.h. also zugeordnet sind.

Zusätzlich umfasst der Wippschalter 10 eine Auswerteeinheit 20, die beispielsweise auf oder unterhalb der Grund- bzw. Frontplatte 11 angeordnet ist. Die Grundplatte 11 kann beispielsweise eine Leiterplatte sein, die die Sensorik 13l und 13r und optionaler Weise die Auswerteeinheit 20 umfasst, wobei die Grundplatte 11 entsprechend einer ersten Variante in die Schaltereinheit (Wippschalter 10) integriert sein kann, d.h. Teil der Schaltereinheit ist. Entsprechend einer zweiten Variante ist die Grundplatte 11 eine externe Platte, auf welche die Schaltereinheit (Wippschalter 10 ohne Sensorik 13l und 13r und ohne Auswerteeinheit 20), z. B. mittels Schrauben befestigt wird. Hierbei kann diese externe Grundplatte 11 auch noch weitere Sensorik für weitere Schalter oder weitere Schaltelemente selbst sowie auch weitere Elektronik beherbergen.

Wie anhand von Fig. 1 dargestellt ist, befindet sich das Betätigungselement 14 gegenüber dem Gehäuse 12 bzw. gegenüber der Grundplatte 11 in einer Neutralstellung. Das Betätigungselement 14 kann sowohl auf der Seite 14r (vgl. durchgezogener Pfeil) als auch auf der Seite 141 (vgl. gestrichelter Pfeil) betätigt werden, so dass sich einmal der Abstand ar und einmal der Abstand al ändert. Der Abstand al repräsentiert nicht nur den Abstand zwischen Betätigungselement 14 und Grundplatte 11 auf der einen Seite, sondern insbesondere auch den Abstand zwischen Magnet 15l und Sensor 131, der infolge der höheren Nähe zu dem Magneten 15l ein stärkeres Magnetfeld detektiert. Der Abstand ar repräsentiert analog den Abstand zwischen dem Magneten 15r und dem Magnetfeldsensor 13r, wobei sich auch hier mit kleiner werdendem Abstand ar ein zunehmend stärker werdendes, detektierbares Magnetfeld am Magnetfeldsensor 13r einstellt. Durch die unterschiedlich gemessenen Magnetfeldstärken an den Sensoren 13l und 13r kann der jeweilige Abstand al bzw. ar stufenlos bestimmt werden.

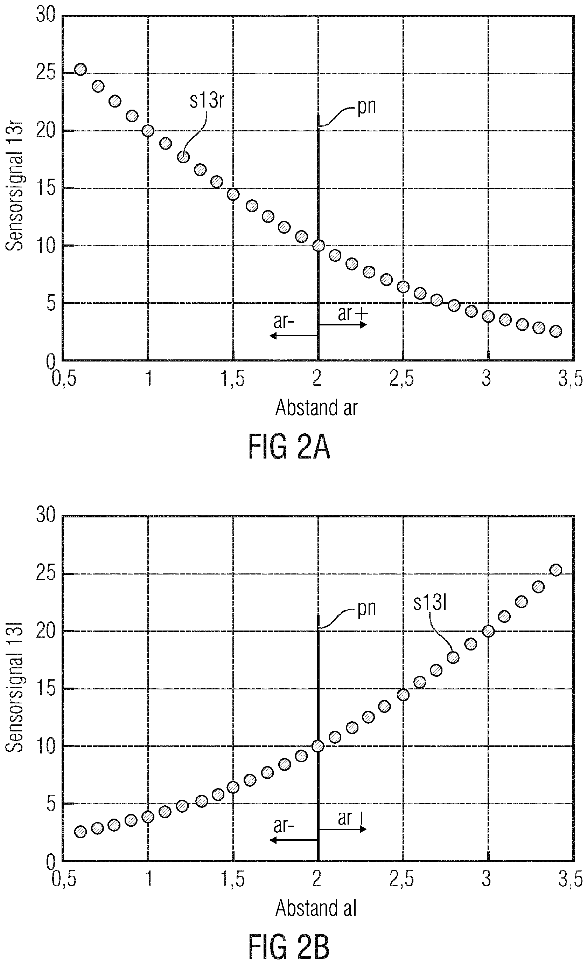

Es ist ferner auch möglich, beispielsweise an den Abstandssensor 13r nicht nur einen Abstand ar zwischen dem Minimum und der Neutralstellung zu detektieren, sondern auch einen Abstand jenseits der Neutralstellung, also beispielsweise wenn der Abstand al bis auf ein Minimum reduziert wird. Das durch den Sensor 13r ausgegebene Sensorsignal s13r in Abhängigkeit von dem Abstand ar ist exemplarisch anhand von Fig. 2a illustriert. Auch Sensor 131 gibt ein Sensorsignal s13l aus, mittels welchen der gesamte Bewegungsbereich von al Minimum bis ar Minimum überwacht werden kann. S13l ist in Fig. 2b (aufgetragen über den Abstand ar) dargestellt.

Aus den zwei Diagrammen (Fig. 2a/2b) ist also deutlich zu erkennen, dass sowohl anhand des Sensorsignais des Sensors 13l als auch anhand des Sensorsignales des Sensors 13r der gesamte Bewegungsbereich von al auf Minimum über Neutralstellung (al = ar) bis ar auf Minimum sensiert werden kann. Ausgehend von dieser Erkenntnis wurde die weitere Erkenntnis gezogen, dass es insbesondere im Hinblick auf die Störunanfälligkeit sinnvoll ist, beide Sensorsignale als Kombination bzw. ein Kombinationssignal der beiden Sensorsignale der Sensoren 13l und 13r auszuwerten. Diese Auswertung übernimmt die Auswerteeinheit 20, welche von den Sensoren 13l und 13r die jeweiligen Sensorsignale empfängt. Die Auswerteeinheit 20 ist ausgebildet, die Bewegung und/oder Position der Wippe 14 relativ zu dem Gehäuse 12 anhand einer Funktion der beiden Sensorsignale der Sensoren 13l und 13r zu bestimmen.

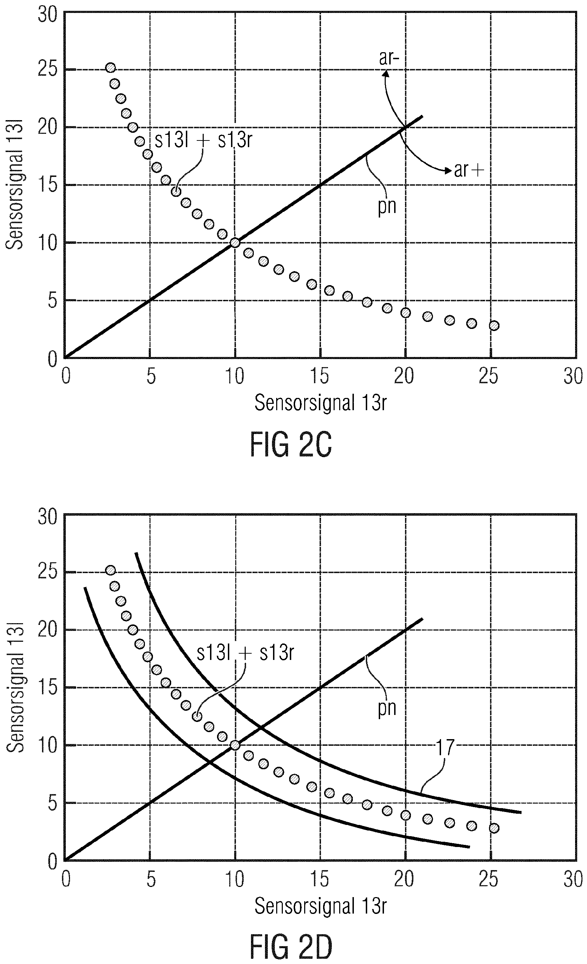

Wie angedeutet ist, erfolgt die Bestimmung anhand des Kombinationssignals, welches beispielsweise als zweidimensionale Funktion, umfassend je Relativposition zwischen Betätigungselement 14 und Gehäuse 12 ein Wertepaar, darstellt. Ein exemplarisches Kombinationssignal, resultierend aus den in Fig. 2a und 2b diskutierten Sensorsignalen s13l und s13r, ist in Fig. 2c dargestellt. Fig. 2c zeigt ein Diagramm, wobei das Sensorsignal s13l des Sensors 13l entlang der y-Achse aufgetragen ist und das Sensorsignal s13r des Sensors 13r entlang der x-Achse. In dieser Darstellung ist das Kombinationssignal mit dem Bezugszeichen s13l + s13r versehen. Des Weiteren ist in dem Diagramm mittels der Linie pn die Neutralposition illustriert. Mittels Pfeilen ausgehend von der Linie sind zwei Bereiche des Abstands ar, nämlich diesseits und jenseits der Neutralstellung mit ar+ und ar- angedeutet, wobei ar- den Bereich von ar Minimum bis zur Neutralstellung darstellt und ar+ im Bereich von der Neutralstellung bis zu ar Maximum. Dieselbe Notation ausgehend von der Neutrallinie pn ist in den Fig. 2a und 2b ebenso eingezeichnet, wobei hier natürlich die Neutrallinie pn nicht eine Nullpunktgerade (wie in Fig. 2c), sondern eben eine Position des Abstands ar ist.

Anhand der Darstellung von Fig. 2c wird klar, dass jede Position entlang des gesamten Bewegungsbereichs (ar- plus ar+) durch eine Kombination der zwei Sensorsignale s13r und s13l, also ein Wertepaar, messtechnisch dargestellt wird. Da das eine Signal (beispielsweise s13r) bei einer Bewegung abnimmt, während das andere Signal (beispielsweise s13l) zunimmt, stellt sich der eben dargestellte Verlauf s13l + s13r ein. Durch die sich antizyklisch verhaltenen Wertepaare ist das Kombinationssignal robust und gegen externe Störungen sehr unanfällig. Hintergrund hierzu ist, dass beispielsweise ein externes magnetisches Störfeld sich auf beide Sensorsignale s13l und s13r gleichermaßen auswirken würde, so dass es zu einer Parallelverschiebung kommt, infolgedessen zwar keine Position und Bewegung mehr zugeordnet werden kann, jedoch verhindert wird, dass eine falsche Position oder falsche Bewegung in das Sensorsignal hineininterpretiert wird. Insofern wird ein Fehler sofort erkenntlich.

Entsprechend Ausführungsbeispielen kann deshalb die Auswerteeinheit 20 ausgebildet sein, um einen Fehler zu erkennen und eine Fehlermeldung auszugeben.

Bei derartigen Schaltern mit zwei Sensorsignalen wird oft eine Differenzbildung gemacht, somit kann eine gewisse Unabhängigkeit von den absoluten Signalen erreicht werden. Dies ist bei Signalen mit nicht-linearen Kennlinien aber schwierig, so dass entweder eine Linearisierung vorgenommen werden sollte oder ganz bewusst auf nicht-lineare Signale gesetzt wird, wie nachfolgend dargestellt wird. Nachfolgend wird anhand von Fig. 2a bis 2c auf ein erweitertes Ausführungsbeispiel eingegangen. Das Auswerteverfahren beschreibt die Auswertung eines Schalters 10 mit zwei Auswerteeinheiten 20, welche beide ein nicht-lineares Verhalten aufweisen.

Die Nichtlinearität ergibt sich daraus, dass im Beispiel des Wippschalters 10 eine Abstandsabhängigkeit mit 1/r bzw. 1/r² vorhanden ist, wobei r der Abstand der Magnete 15l und 15r von der Rotationsachse 18 ist. Das nichtlineare Verhalten ist aber auch gewollt, da dadurch die Auswertung der zwei (infolge der Betätigung) entgegengesetzt verhaltenden Sensorsignale S12l und S13r erleichtert wird. Das bedeutet im Beispiel des Wippschalters 10, dass bei der Betätigung der Betrag des Signals S13r zunimmt und das zweite Signal S13l abnimmt. Da sich in vielen Sensoranwendungen das Sensorsignal nicht-linear zum Abstand ändert, wird dieses Verfahren angewandt. So können in dem genannten Fall des Wippschalters 10 die Sensorsignale S13l und S13r in Abhängigkeit vom Abstand ar folgendermaßen aussehen. Die neutrale Stellung ist hier mit pn gekennzeichnet.

Ausgehend von diesen nicht-linearen Sensorsignalen s13l und s13r wird nun das Kombinationssignal s13l + s13r (z.B. durch Faltung oder Multiplikation) ermittelt. Die hier zugrundeliegende Idee ist, wenn die Signale s13l und s13r schon mechanisch miteinander verbunden sind, können diese auch mathematisch miteinander gekoppelt werden. Das Sensorsignal s13r ist eine Funktion des Sensorsignals s13l. Durch die in Fig. 2c dargestellte Kombination ergibt sich aufgrund des nicht-linearen Verhaltens der einzelnen Sensorsignale s13l und s13r auch ein nicht-linearer Verlauf des Sensorsignals s13l + s13r.

Trotz des nicht-linearen Verlaufs des Kombinationssignals s131 + s13r ist die neutrale Stellung immer die diagonale pn (vgl. Fig. 2c) unabhängig, wie groß die Signale s13l bzw. s13r sind. Die Schaltpunkte (Signaipaare, weiche anhand der Punkte der Funktion s13l + s13r dargestellt sind, sind somit auch voneinander abhängig und bekommen so einen Sicherheitscharakter. Der Schalter kann nur auslösen bzw. die Bewegung des Schalters 10 oder die Position des Schalters 10 bzw. der Wippe 14 kann nur ausgewertet werden, wenn die Messwerte s13l + s13r auf der dargestellten Kurve liegen.

Da es doch unterschiedlichste Toleranzen und Ungenauigkeiten gibt, kann nicht die Funktion selbst verwendet werden, sondern es muss ein gültiger Bereich um die Kurve erstellt werden, wie in Fig. 2d gezeigt ist.

Legt man um diese Funktion nun eine Hüllkurve 17, sind nur alle Werte innerhalb der Hüllkurve 17 gültig, alle Punkte, die außerhalb der Kurve 17 liegen, sind ungültig bzw. Folge einer Fehlmessung. Zum Beispiel: Sind die Punkte s13c + s13l außerhalb der Hüllkurve 17, liegt z.B. ein Fremdmagnetfeld an, oder der Temperaturbereich wurde überschritten, oder ein Magnet ist defekt oder hat sich aus der Halterung gelöst.

Der Vorteil zu einer reinen Differenzbildung liegt darin, dass auch nicht-lineare Funktionen überwacht werden können.

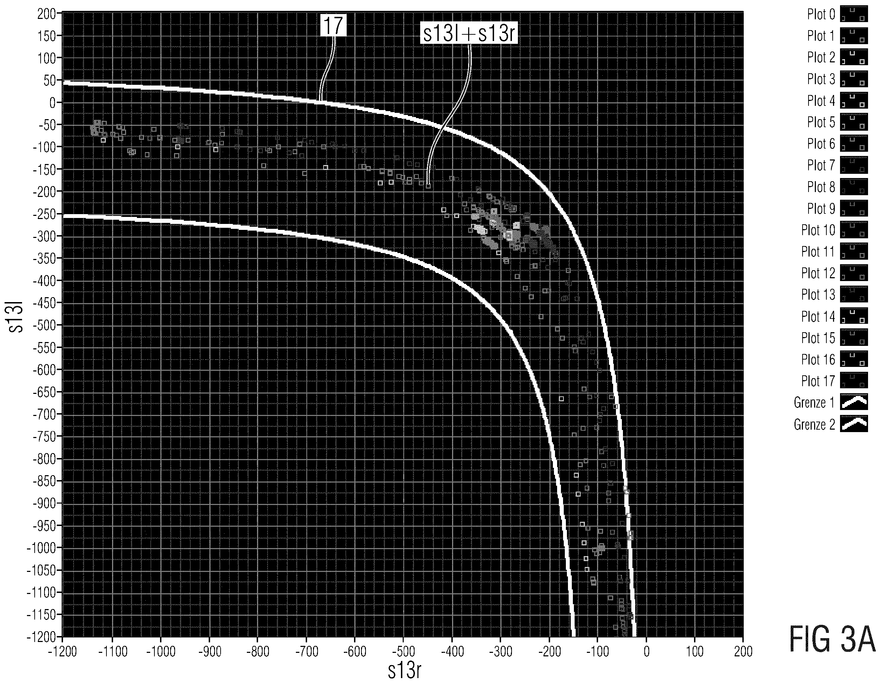

Fig. 3a-c zeigen weitere schematische Diagramme, die das resultierende Kombinationssignal s13l + s13r zusammen mit der eingestellten Hüllkurve 17 darstellen. Wie zu erkennen ist, stellt sich in den Fig. 3a-c das Kombinationssignal s13l + s13r nicht als Linie mit einer Vielzahl an Wertpaaren der Signale s13l (x-Achse) und s13r (y-Achse) dar, sondern eher als Punktewolke, die sich entlang einer Funktion erstreckt, wobei jeder Punkt eben ein Wertepaar (s13l in Kombination mit s13r) darstellt. Ferner ist auch zu erkennen, dass in diesem Ausführungsbeispiel im Gegensatz zu den Ausführungsbeispielen aus den Fig. 2a-2d die Funktion nicht in Form von 1:x im ersten Quadranten, sondern in Form von 1:x im dritten Quadranten vorliegt.

Alle Messwerte der Funktion s13l + s13r in dem in Fig. 3a dargestellten Fall liegen innerhalb der Hüllkurve 17, was auf eine gültige Messung hindeutet. An dieser Stelle sei erwähnt, dass entsprechend Ausführungsbeispielen die Hüllkurve 17 durch Veränderung der Funktionsparameter der Funktion s13l + s13r gewonnen wurde.

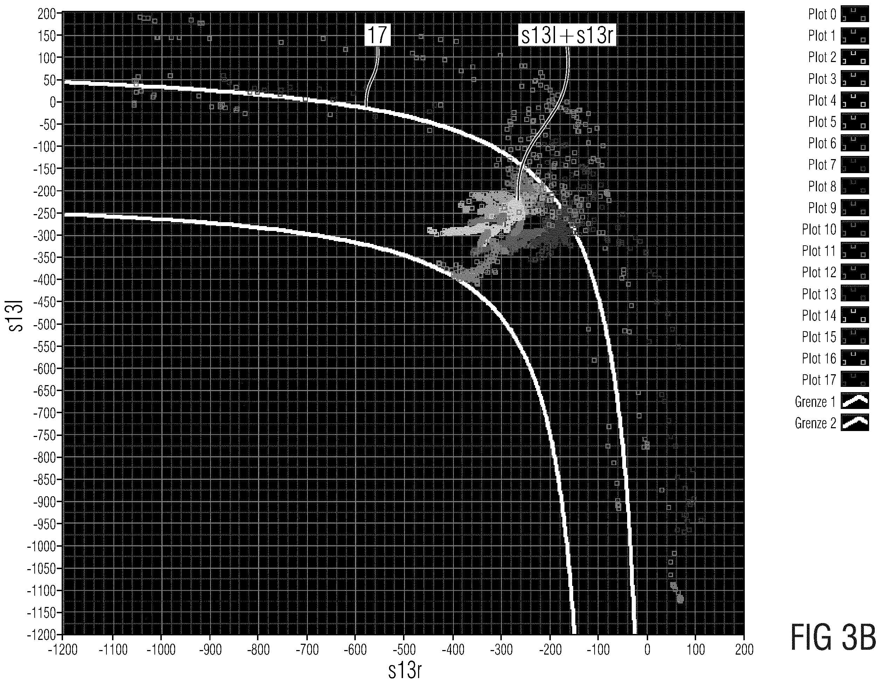

Liegen die Werte s13l + s13r außerhalb der Hüllkurve 17, so liegt ein Fehler vor oder es ist ein Störfeld vorhanden, wie anhand der Fig. 3b gezeigt ist. Bei Fig. 3b detektiert sowohl der erste Sensor (vgi. Signal d13l) ais auch der zweite Sensor (vgi. d13r) einen erhöhten Signalwert, so dass hier davon auszugehen ist, dass ein Störfeld vorliegt, da die Messwerte außerhalb der Hüllkurve 17 bzw. zumindest größtenteils außerhalb der Hüllkurve 17 liegen.

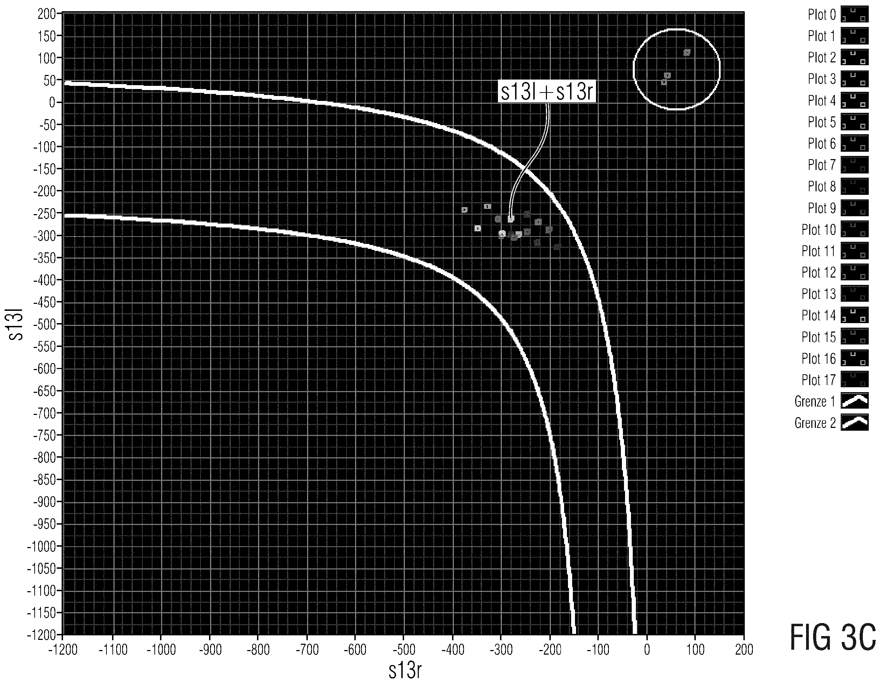

Bei Fig. 3c kann gar nicht über den gesamten Bewegungsbereich eine Funktion des Kombinationssignals s13l + s13r dargestellt werden, was darauf hindeutet, dass entweder der Schalter einen fehlerhaften Aufbau aufweist oder defekt ist. Hierauf deuten insbesondere die Messwerte innerhalb des Kreises hin.

Also ist es auch ausgehend von den Funktionen s13l + s13r, wie sie in den Fig. 3a-c dargestellt sind, möglich, die Signale s13l + s13r derart zu überwachen, dass über deren Zulässigkeit entschieden werden kann. Die Zuverlässigkeit der Signale wird dadurch deutlich erhöht. Es kann ein Störfeld erkannt werden und ein sicheres Schalten gewährleistet werden. Der Aufbau ist ausgehend von der breit gewählten Hüllkurve 17 unabhängig von Toleranzen.

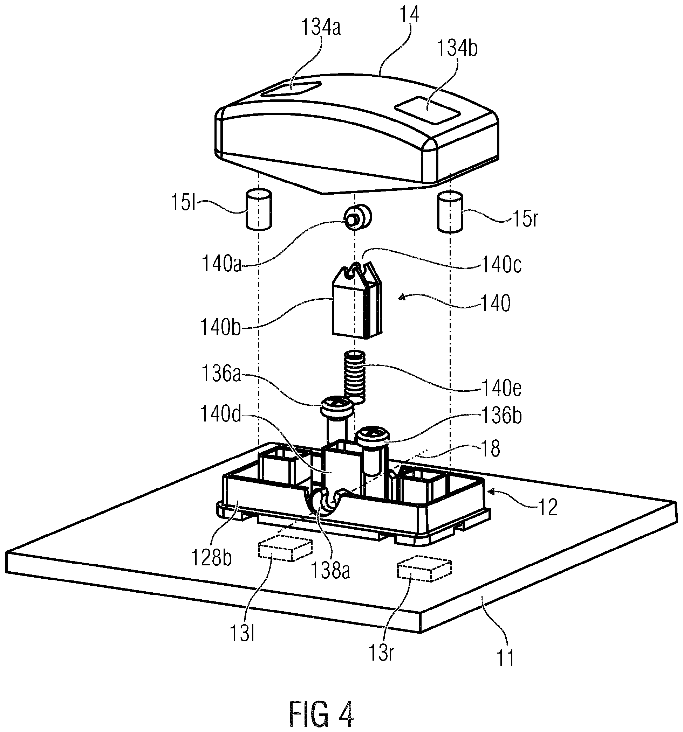

Fig. 4 zeigt eine Expositionsdarstellung eines Wippschalters zur Darstellung von dessen Innenaufbau. Das Gehäuse 12 ist auf einer Grund- oder Frontplatte 11 mittels der Schrauben 136a und 136b befestigt. Das Gehäuse 12 umfasst eine umlaufende Seitenwandung 128b, die im Bereich einer Aufnahme 138a für ein Rastelement eine Aussparung aufweist. Durch diese Aussparung verläuft die Drehachse 18, um welche sich die Wippe 14 in Bezug zum Gehäuse 12 bzw. zur Grundplatte 11 bewegen lässt. Anstelle von Schrauben 136a und 136b zur Befestigung des Gehäuseoberteils 12 an einem (nicht dargestellten) Gehäuseunterteil bzw. an der Grundplatte 11 kann diese Befestigung gemäß anderen Ausführungsbeispielen auch durch eine Rastvorrichtung erfolgen. Anders ausgedrückt heißt das, dass zwischen Grundplatte 11 und der Wippe 14 das Gehäuse 12 auf der Grundplatte 11 lösbar angeordnet ist, an welchem die Wippe 14 wiederum lösbar angeordnet ist.

In einem mittleren Bereich des Gehäuseoberteils 12 ist eine bewegbare mechanische Rückstelleinrichtung angeordnet, die in ihrer Gesamtheit mit dem Bezugszeichen 140 bezeichnet ist, innerhalb des Betätigungselements 14 angeordnete Aufnahme und ein Rückstellelement 140a in Form eines Rades aufweist, welches innerhalb eines Verbindungsstücks 140b drehbar gelagert ist. Das Verbindungsstück 140b umfasst einen Körper, an dessen oberen Ende, welches dem Betätigungselement 14 zugewandt ist, ein Lager 140c zur drehbaren Aufnahme des Rades 140a gebildet ist. Das Verbindungsstück 140b ist innerhalb einer Halterung 140d, die im Wesentlichen mittig im Gehäuseoberteil 12 angeordnet ist, eingefügt. Das Verbindungsstück 140b ist beweglich innerhalb der Halterung 140d angeordnet und wird durch die Halterung 140d derart geführt, dass eine vertikale Bewegung des Verbindungsstücks, also eine Bewegung innerhalb der Halterung 140d in Richtung des Betätigungselements 14 bzw. in Richtung des Gehäuseoberteils 12 ermöglicht ist. Die Rückstelleinrichtung 140 umfasst ferner ein Federelement 140e, welches zwischen einer Unterseite des Verbindungsstücks 140b und dem Gehäuseoberteil 12 angeordnet ist. Gemäß Ausführungsbeispielen ist das Rad 140a und die Feder 140e im oberen Bereich bzw. im unteren Bereich des Verbindungsstücks 140b lösbar angeordnet. Die Rückstelleinrichtung 140 dient dazu, das Betätigungselement 14 in nichtbetätigtem Zustand in einer Mittelposition zu halten, und um nach einer Betätigung und dem Loslassen des Betätigungselements 14 sicherzustellen, dass das Betätigungselement in die Mittelposition bzw. die neutrale Position zurückbewegt wird, wie es nachfolgend noch näher erläutert wird.

Der Wippschalter umfasst ferner zwei magnetfelderzeugende Positionselemente 15l und 15r, beispielsweise in Form von Dauermagneten, welche innerhalb des Betätigungselements 14 in der (hier nicht dargestellten) Halterung angeordnet sind und sich entsprechend einer Bewegung des Betätigungselements 14 bewegen. Die den Positionselementen 15l und 15r zugeordneten Sensorelemente sind mit den Bezugszeichen 13r und 13l versehen und befinden sich unter dem Gehäuse 12 und auch unter der Grundplatte 11.

Auch in obigen Ausführungsbeispielen, wie insbesondere im Zusammenhang mit dem einzelnen Wippschalter, der eine zweidimensionale Bewegung aufweist, erläutert wurde, sei darauf hingewiesen, dass oben angesprochenes Auswertungsverfahren auch auf vierdimensionale Wippschalter, also z.B. sternförmige Wippschalter mit insgesamt zwei Wippen, übertragen werden kann.

Weitere Ausführungsbeispiele beziehen sich auf eine Steuer- und Bedieneinheit mit zumindest einem der oben erläuterten Wippschalter. Die Steuer- und Bedieneinheit kann beispielsweise bei einer Baumaschine oder einer Hubarbeitsbühne Verwendung finden.

Auch wenn obige Ausführungsbeispiele insbesondere im Zusammenhang mit einer Vorrichtung, nämlich dem Wippschalter erläutert wurden, sei darauf hingewiesen, dass sich weitere Ausführungsbeispiele auf das entsprechende Auswerteverfahren beziehen. Somit schaffen weitere Ausführungsbeispiele ein Verfahren zum Betreiben einer Wippschaltvorrichtung mit dem zentralen Schritt "Auswerten des Kombinationssignals der zwei Sensorsignale, um ausgehend von dem Kombinationssignal eine Position und/oder eine Bewegung des Positionselements zu bestimmen".

Dieses Verfahren kann dahin gehend erweitert werden, dass eine Störungsposition, wie sie oben beschrieben ist, mit integriert wird. Somit stellt das Verfahren also sicher, dass ein magnetischer Schalter nur dann schaltet, wenn keine Störung vorhanden ist. Somit kann ein unabsichtliches Verfahren von Maschinenteilen verhindert werden, da die entsprechende Fehlerdetektion vorab anspringt.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar. Einige oder alle der Verfahrensschritte können durch einen Hardware-Apparat (oder unter Verwendung eines Hardware-Apparats), wie zum Beispiel einen Mikroprozessor, einen programmierbaren Computer oder eine elektronische Schaltung ausgeführt werden. Bei einigen Ausführungsbeispielen können einige oder mehrere der wichtigsten Verfahrensschritte durch einen solchen Apparat ausgeführt werden.

Je nach bestimmten Implementierungsanforderungen können Ausführungsbeispiele der Erfindung in Hardware oder in Software implementiert sein. Die Implementierung kann unter Verwendung eines digitalen Speichermediums, beispielsweise einer Floppy-Disk, einer DVD, einer Blu-ray Disc, einer CD, eines ROM, eines PROM, eines EPROM, eines EEPROM oder eines FLASH-Speichers, einer Festplatte oder eines anderen magnetischen oder optischen Speichers durchgeführt werden, auf dem elektronisch lesbare Steuersignale gespeichert sind, die mit einem programmierbaren Computersystem derart zusammenwirken können oder zusammenwirken, dass das jeweilige Verfahren durchgeführt wird. Deshalb kann das digitale Speichermedium computerlesbar sein.

Manche Ausführungsbeispiele gemäß der Erfindung umfassen also einen Datenträger, der elektronisch lesbare Steuersignale aufweist, die in der Lage sind, mit einem programmierbaren Computersystem derart zusammenzuwirken, dass eines der hierin beschriebenen Verfahren durchgeführt wird.

Allgemein können Ausführungsbeispiele der vorliegenden Erfindung als Computerprogrammprodukt mit einem Programmcode implementiert sein, wobei der Programmcode dahin gehend wirksam ist, eines der Verfahren durchzuführen, wenn das Computerprogrammprodukt auf einem Computer abläuft.

Der Programmcode kann beispielsweise auch auf einem maschinenlesbaren Träger gespeichert sein.

Andere Ausführungsbeispiele umfassen das Computerprogramm zum Durchführen eines der hierin beschriebenen Verfahren, wobei das Computerprogramm auf einem maschinenlesbaren Träger gespeichert ist.

Mit anderen Worten ist ein Ausführungsbeispiel des erfindungsgemäßen Verfahrens somit ein Computerprogramm, das einen Programmcode zum Durchführen eines der hierin beschriebenen Verfahren aufweist, wenn das Computerprogramm auf einem Computer abläuft.

Ein weiteres Ausführungsbeispiel der erfindungsgemäßen Verfahren ist somit ein Datenträger (oder ein digitales Speichermedium oder ein computerlesbares Medium), auf dem das Computerprogramm zum Durchführen eines der hierin beschriebenen Verfahren aufgezeichnet ist.

Ein weiteres Ausführungsbeispiel des erfindungsgemäßen Verfahrens ist somit ein Datenstrom oder eine Sequenz von Signalen, der bzw. die das Computerprogramm zum Durchführen eines der hierin beschriebenen Verfahren darstellt bzw. darstellen. Der Datenstrom oder die Sequenz von Signalen kann bzw. können beispielsweise dahin gehend konfiguriert sein, über eine Datenkommunikationsverbindung, beispielsweise über das Internet, transferiert zu werden.

Ein weiteres Ausführungsbeispiel umfasst eine Verarbeitungseinrichtung, beispielsweise einen Computer oder ein programmierbares Logikbauelement, die dahin gehend konfiguriert oder angepasst ist, eines der hierin beschriebenen Verfahren durchzuführen.

Ein weiteres Ausführungsbeispiel umfasst einen Computer, auf dem das Computerprogramm zum Durchführen eines der hierin beschriebenen Verfahren installiert ist.

Ein weiteres Ausführungsbeispiel gemäß der Erfindung umfasst eine Vorrichtung oder ein System, die bzw. das ausgelegt ist, um ein Computerprogramm zur Durchführung zumindest eines der hierin beschriebenen Verfahren zu einem Empfänger zu übertragen. Die Übertragung kann beispielsweise elektronisch oder optisch erfolgen. Der Empfänger kann beispielsweise ein Computer, ein Mobilgerät, ein Speichergerät oder eine ähnliche Vorrichtung sein. Die Vorrichtung oder das System kann beispielsweise einen Datei-Server zur Übertragung des Computerprogramms zu dem Empfänger umfassen.

Bei manchen Ausführungsbeispielen kann ein programmierbares Logikbauelement (beispielsweise ein feldprogrammierbares Gatterarray, ein FPGA) dazu verwendet werden, manche oder alle Funktionalitäten der hierin beschriebenen Verfahren durchzuführen. Bei manchen Ausführungsbeispielen kann ein feldprogrammierbares Gatterarray mit einem Mikroprozessor zusammenwirken, um eines der hierin beschriebenen Verfahren durchzuführen. Allgemein werden die Verfahren bei einigen Ausführungsbeispielen seitens einer beliebigen Hardwarevorrichtung durchgeführt. Diese kann eine universell einsetzbare Hardware wie ein Computerprozessor (CPU) sein oder für das Verfahren spezifische Hardware, wie beispielsweise ein ASIC.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

## Patentansprüche

1. Eine Wippschaltvorrichtung (10), mit folgenden Merkmalen:
einem Gehäuse (12);
einem an dem Gehäuse (12) befestigten Betätigungselement (14);
einer Auswerteeinheit (20); und
einer Grundplatte (11);
wobei das Gehäuse (12) an der Grundplatte (11) befestigt ist,
wobei das Betätigungselement (14) relativ gegenüber dem Gehäuse (12) um zumindest eine Drehachse (18) bewegbar ist und zumindest zwei Magnete (15l, 15r) aufweist,
wobei an oder in der Grundplatte (11) zumindest zwei den Magneten (15l, 15r) gegenüberliegende Magnetfeldsensoren (13l, 13r) ortsfest gekoppelt sind, die jeweils in Abhängigkeit eines Abstands (al, ar) zwischen dem jeweiligen Magnetfeldsensor (13l, 13r) und dem zugeordneten Magneten (15l, 15r) ein Sensorsignal (s13r, a13l) ausgeben, **dadurch gekennzeichnet, dass** die Auswerteeinheit (20) ausgebildet ist, um ein Kombinationssignal der zwei Sensorsignale (s13r, s13l) auszuwerten, um ausgehend von dem Kombinationssignal eine Position und/oder eine Bewegung des Betätigungselements (14) zu ermitteln, wobei das Kombinationssignal je Position in dem Bewegungsbereich des Betätigungselements (14) relativ zu dem Gehäuse (12) durch ein Wertepaar gebildet ist, das die zwei Sensorsignale (s13r, s13l) umfasst;
wobei die Auswerteeinheit (20) ausgebildet ist, das Kombinationssignal mit einem Gültigkeitswertebereich, der einen normalen Arbeitsbereich der Sensorelemente repräsentiert, zu vergleichen und die Position und/oder die Bewegung des Betätigungselements (14) nur zu bestimmen, wenn das Kombinationssignal innerhalb des Gültigkeitswertebereichs liegt;
wobei die Auswerteeinheit (20) ausgebildet ist, einen Fehler in Form eines externen Magnetfelds und in Form eines Defekts eines der Sensorelemente, einer Überschreitung des Temperaturbereichs und/oder eines mechanischen Defekts anhand des Kombinationssignals zu erkennen, wobei ein Fehler vorliegt, wenn das Kombinationssignal außerhalb des Gültigkeitswertebereichs liegt; wobei die Auswerteeinheit (20) ein externes Magnetfeld erkennt, wenn die zwei Sensorsignale (s13r, s13l) außerhalb des durch eine Hüllkurve (17) definierten Gültigkeitswertebereichs liegen, und/oder wobei die Auswerteeinheit (20) den Defekt eines der Sensorelemente oder den mechanischen Defekt erkennt, wenn die Funktion des Kombinationssignals nicht über den gesamten Bewegungsbereich dargestellt werden kann.

2. Wippschaltvorrichtung (10) gemäß Anspruch 1, wobei die Magnete (15l, 15r) jeweils auf gegenüberliegenden Seiten des Betätigungselements (14) in Bezug auf die Drehachse (18) angeordnet sind, so dass bei Betätigung des Betätigungselements (14) ein Abstand (al, ar) zwischen Magnet (15l, 15r) und zugeordnetem Magnetfeldsensor (13l, 13r) reduziert wird, während ein Abstand (al, ar) des anderen Magneten (15l, 15r) zu dem zugeordneten anderen Magnetfeldsensor (13l, 13r) erhöht wird.

3. Wippschaltvorrichtung (10) gemäß einem der vorherigen Ansprüche, wobei das Sensorsignal (s13r, s13l) des einen Magnetfeldsensors (13l) mit zunehmendem Abstand (ar) zwischen dem anderen Magnetfeldsensor (13r) und dem zugeordneten Magnet (15r) zunimmt, und wobei das Signal des anderen Magnetfeldsensors (13r) mit zunehmendem Abstand (ar) zwischen dem anderen Magnetfeldsensor (13r) und dem zugeordneten anderen Magneten (15r) abnimmt.

4. Wippschaltvorrichtung (10) gemäß Anspruch 3, wobei ein Signalverlauf für die beiden Magnetfeldsensoren (13l, 13r) über den Abstand (al, ar) zwischen dem Magnetfeldsensor (13l, 13r) und dem zugeordneten Magnet (15l, 15r) und zwischen dem anderen Magnetfeldsensor (13l, 13r) und dem zugeordneten anderen Magnet (15l, 15r) nicht-linear ist.

5. Wippschaltvorrichtung (10) gemäß einem der Ansprüche 1 bis 4, wobei das Kombinationssignal über den Bewegungsbereich des Betätigungselements (14) relativ zu dem Gehäuse (12) einen nicht-linearen Verlauf hat.

6. Wippschaltvorrichtung (10) gemäß einem der Ansprüche 1 bis 5, wobei der Gültigkeitswertebereich durch eine Hüllkurve, die einen Signalverlauf des Kombinationssignals über den Bewegungsbereich des Betätigungselements (14) relativ zu dem Gehäuse (12) einhüllt, definiert ist.

7. Wippschaltvorrichtung (10) gemäß Anspruch 6, wobei eine Breite der Hüllkurve von mechanischen Fertigungstoleranzen der Wippschaltvorrichtung (10) abhängig ist.

8. Wippschaltvorrichtung (10) gemäß einem der vorherigen Ansprüche, wobei zwischen dem Gehäuse (12) und dem Betätigungselement (14) ein Rückstellelement angeordnet ist, das dazu ausgebildet ist, um das Betätigungselement (14) gegenüber dem Gehäuse (12) in die Neutralposition zu bewegen, in welchem ein Abstand (al, ar) zwischen einem Sensorelement und dem zugeordneten Magnet (15l, 15r) einem Abstand (al, ar) zwischen dem anderen Sensorelement und ihm zugeordneten Magnet mit einer Abweichung von ± 15% gleicht.

9. Wippschaltvorrichtung (10) gemäß einem der vorherigen Ansprüche, wobei das Betätigungselement (14) gegenüber dem Gehäuse (12) um eine zweite Drehachse (18) bewegbar ist und zwei weitere Magnete (15l) aufweist, und
wobei an oder in der Grundplatte (11) zumindest zwei den weiteren Magneten (15l) gegenüberliegende weitere Magnetfeldsensoren (13l, 13r) ortsfest gekoppelt sind, die jeweils in Abhängigkeit eines Abstands (al, ar) zwischen dem jeweiligen Magnetfeldsensor (13l, 13r) und dem zugeordneten Magnet (15l, 15r) ein Sensorsignal (s13r, s13l) ausgeben.

10. Steuer- und Bedieneinheit für eine Hubarbeitsbühne, eine mobile Arbeitsmaschine oder eine Baumaschine mit einer Wippschaltvorrichtung (10) gemäß einem der vorherigen Ansprüche.

11. Verfahren zum Betreiben einer Wippschaltvorrichtung (10), die ein Gehäuse (12), ein an das Gehäuse (12) befestigtes Betätigungselement (14) und eine Grundplatte (11) umfasst, und wobei das Betätigungselement (14) in Bezug auf das Gehäuse (12) um zumindest eine Drehachse (18) bewegbar ist und zumindest zwei Magnete (15l, 15r) aufweist, wobei das Gehäuse (12) an der Grundplatte (11) befestigt ist und wobei an oder in der Grundplatte (11) zumindest zwei den Magneten (15l, 15r) gegenüberliegenden Magnetfeldsensoren (13l, 13r) ortsfest gekoppelt sind, die jeweils in Abhängigkeit eines Abstands (al, ar) zwischen dem jeweiligen Magnetfeldsensor (13l, 13r) und dem zugeordneten Magneten (15l, 15r) ein Sensorsignal (s13r, s13l) ausgibt, **gekennzeichnet durch** Auswerten eines Kombinationssignals der zwei Sensorsignale (s13r, s13l), um ausgehend von dem Kombinationssignal eine Position und/oder eine Bewegung des Betätigungselements zu ermitteln, wobei das Kombinationssignal je Position in dem Bewegungsbereich des Betätigungselements (14) relativ zu dem Gehäuse (12) durch ein Wertepaar gebildet ist, das die zwei Sensorsignale (s13r, s13l) umfasst;
wobei das Auswerten ein Vergleichen des Kombinationssignals mit einem Gültigkeitswertebereich, der einen normalen Arbeitsbereich der Sensorelemente repräsentiert, umfasst, wobei die Position und/oder die Bewegung des Betätigungselements (14) nur bestimmt wird, wenn das Kombinationssignal innerhalb des Gültigkeitswertebereichs liegt;
wobei das Auswerten ein Erkennen eines Fehlers in Form eines externen Magnetfelds oder eines Fehlers in Form eines Defekts eines der Sensorelemente, einer Überschreitung des Temperaturbereichs und/oder eines mechanischen Defekts anhand des Kombinationssignals umfasst, wobei ein Fehler vorliegt, wenn das Kombinationssignal außerhalb des Gültigkeitswertebereichs liegt; wobei das externe Magnetfeld erkannt wird, wenn die zwei Sensorsignale (s13r, s13l) außerhalb des durch eine Hüllkurve (17) definierten Gültigkeitswertebereichs liegen, und/oder wobei der Defekt eines der Sensorelemente oder der mechanische Defekt erkannt wird, wenn die Funktion des Kombinationssignals nicht über den gesamten Bewegungsbereich dargestellt werden kann.

12. Computerprogramm zum Durchführen des Verfahrens nach Anspruch 11, wenn das Programm auf dem Computer ausgeführt wird.

## Claims

1. Rocker switch device (10) comprising:
a housing (12);
an actuation element (14) attached to the housing (12);
an evaluation unit (20); and
a base plate (11);
wherein the housing (12) is attached to the base plate (11),
wherein the actuation element (14) is movable relative with respect to the housing (12) around at least one rotation axis (18), and comprises at least two magnets (15l, 15r),
wherein at least two magnetic field sensors (13l, 13r) opposite to the magnets (15l, 15r) are coupled at or in the base plate (11) in a stationary manner, which each output a sensor signal (s13r, a13l) depending on a distance (al, ar) between the respective magnetic field sensor (13l, 13r) and the associated magnet (15l, 15r),
**characterized in that** the evaluation unit (20) is configured to evaluate a combination signal of the two sensor signals (s13r, s13l) in order to determine a position and/or a movement of the actuation element (14) based on the combination signal, wherein the combination signal, per position in the movement range of the actuation element (14) relative to the housing (12), is formed by a value pair that includes the two sensor signals (s13r, s13l);
wherein the evaluation unit (20) is configured to compare the combination signal to a validity value range that represents a normal working range of the sensor elements, and to only determine the position and/or the movement of the actuation element (14) when the combination signal is located inside of the validity value range;
wherein the evaluation unit (20) is configured to detect, based on the combination signal, an error in form of an external magnetic field and in form of a defect of one of the sensor elements, an exceedance of the temperature range and/or a mechanical defect, wherein an error is present when the combination signal is located outside of the validity value range;
wherein the evaluation unit (20) detects an external magnetic field when the two sensor signals (s13r, s13l) are located outside of the validity value range defined by an envelope (17), and/or wherein the evaluation unit (20) detects the defect of one of the sensor elements or the mechanical defect when the function of the combination signal cannot be represented over the entire movement range.

2. Rocker switch device (10) according to claim 1, wherein the magnets (15l, 15r) are each arranged on opposite sides of the actuation element (14) with respect to the rotation axis (18) so that, upon actuation of the actuation element (14), a distance (al, ar) between one magnet (15l, 15r) and the associated magnetic field sensor (13l, 13r) is reduced, while a distance (al, ar) of the other magnet (15l, 15r) to the associated other magnetic field sensor (13l, 13r) is increased.

3. Rocker switch device (10) according to any one of the preceding claims, wherein the sensor signal (s13r, s13l) of the one magnetic field sensor (13l) increases with increasing distance (ar) between the other magnetic field sensor (13r) and the associated magnet (15r), and wherein the signal of the other magnetic field sensor (13r) decreases with increasing distance (ar) between the other magnetic field sensor (13r) and the associated other magnet (15r).

4. Rocker switch device (10) according to claim 3, wherein a signal progression for the two magnetic field sensors (13l, 13r) across the distance (al, ar) between the magnetic field sensor (13l, 13r) and the associated magnet (15l, 15r) and between the other magnetic field sensor (13l, 13r) and the associated other magnet (15l, 15r) is non-linear.

5. Rocker switch device (10) according to any one of claims 1 to 4, wherein the combination signal across the movement range of the actuation element (14) relative to the housing (12) comprises a non-linear progression.

6. Rocker switch device (10) according to any one of claims 1 to 5, wherein the validity value range is defined by an envelope that envelops a signal progression of the combination signal across the movement range of the actuation element (14) relative to the housing (12).

7. Rocker switch device (10) according to claim 6, wherein a width of the envelope depends on mechanical manufacturing tolerances of the rocker switch device (10).

8. Rocker switch device (10) according to any one of the preceding claims, wherein a restoring element is arranged between the housing (12) and the actuation element (14), which is configured to move the actuation element (14) with respect to the housing (12) into the neutral position, in which a distance (al, ar) between a sensor element and the associated magnet (15l, 15r) is equal with a deviation of ±15% to a distance (al, ar) between the other sensor element and the magnet associated thereto.

9. Rocker switch device (10) according to any one of the preceding claims, wherein the actuation element (14) is movable with respect to the housing (12) around a second rotation axis (18), and comprises two further magnets (15l), and
wherein at least two further magnetic field sensors (13l, 13r) opposite to the further magnets (15l) are coupled at or in the base plate (11) in a stationary manner, which each output a sensor signal (s13r, s13l) depending on a distance (al, ar) between the respective magnetic field sensor (13l, 13r) and the associate magnet (15l, 15r).

10. Control and operating unit for an elevating platform, a mobile work machine or a construction machine having a rocker switch device (10) according to any one of the preceding claim.

11. Method for operating a rocker switch device (10) that includes a housing (12), an actuation element (14) attached to the housing (12), and a base plate (11), wherein the actuation element (14) is movable relative with respect to the housing (12) around at least one rotation axis (18) and comprises at least two magnets (15l, 15r), wherein the housing (12) is attached to the base plate (11) and wherein at least two magnetic field sensors (13l, 13r) opposite to the magnets (15l, 15r) are coupled at or in the base plate (11) in a stationary manner, which each output a sensor signal (s13r, a13l) depending on a distance (al, ar) between the respective magnetic field sensor (13l, 13r) and the associated magnet (15l, 15r), **characterized by**
evaluating a combination signal of the two sensor signals (s13r, s13l) in order to determine a position and/or a movement of the actuation element based on the combination signal, wherein the combination signal, per position in the movement range of the actuation element (14) relative to the housing (12), is formed by a value pair that includes the two sensor signals (s13r, s13l);
wherein evaluating includes comparing the combination signal to a validity value range that represents a normal working range of the sensor elements, wherein the position and/or the movement of the actuation element (14) is only determined when the combination signal is located inside of the validity value range;
wherein evaluating includes detecting, based on the combination signal, an error in form of an external magnetic field or an error in form of a defect of one of the sensor elements, an exceedance of the temperature range and/or a mechanical defect, wherein an error is present when the combination signal is located outside of the validity value range;
wherein the external magnetic field is detected when the two sensor signals (s13r, s13l) are located outside of the validity value range defined by an envelope (17), and/or wherein the defect of one of the sensor elements or the mechanical defect is detected when the function of the combination signal cannot be represented over the entire movement range.

12. Computer program for performing the method according to claim 11 when the program is executed on the computer.

## Revendications

1. Dispositif de circuit de bascule (10), aux caractéristiques suivantes:
un boîtier (12);
un élément d'actionnement (14) fixé au boîtier (12);
une unité d'évaluation (20); et
une plaque de base (11);
dans lequel le boîtier (12) est fixé à la plaque de base (11),
dans lequel l'élément d'actionnement (14) est déplaçable par rapport au boîtier (12) autour d'au moins un axe de rotation (18) et présente au moins deux aimants (15l, 15r),
dans lequel sont couplés de manière stationnaire à ou dans la plaque de base (11) au moins deux capteurs de champ magnétique (13l, 13r) opposés aux aimants (15l, 15r) qui émettent, chacun, un signal de capteur (s13r, a13l) en fonction d'une distance (al, ar) entre le capteur de champ magnétique respectif (13l, 13r) et l'aimant associé (15l, 15r),
**caractérisé par le fait que**
l'unité d'évaluation (20) est conçue pour évaluer un signal de combinaison des deux signaux de capteur (s13r, s13l) pour déterminer, à partir du signal de combinaison, la position et/ou un déplacement de l'élément d'actionnement (14), où le signal de combinaison est formé, par position dans la plage de déplacement de l'élément d'actionnement (14) par rapport au boîtier (12), par une plaire de valeurs qui comprend les deux signaux de capteur (s13r, s13l);
dans lequel l'unité d'évaluation (20) est conçue pour comparer le signal de combinaison avec une plage de valeurs de validité qui représente une plage de fonctionnement normal des éléments capteurs, et pour ne déterminer la position et/ou le déplacement de l'élément d'actionnement (14) que lorsque le signal de combinaison se situe dans la plage de valeurs de validité;
dans lequel l'unité d'évaluation (2,0) est conçue pour reconnaître, à l'aide du signal de combinaison, une erreur sous forme d'un champ magnétique extérieur et sous forme d'un défaut de l'un des éléments capteurs, d'un dépassement de la plage de températures et/ou d'un défaut mécanique, où une erreur est présente lorsque le signal de combinaison se situe en dehors de la plage de valeurs de validité;
dans lequel l'unité d'évaluation (20) reconnaît un champ magnétique extérieur lorsque les deux signaux de capteur (s13r, s131) se situent en dehors de plage de valeurs de validité définie par une enveloppe (17), et/ou dans lequel l'unité d'évaluation (20) reconnaît le défaut de l'un des éléments capteurs ou le défaut mécanique lorsque la fonction du signal de combinaison ne peut pas être représentée sur toute la plage de déplacement.

2. Dispositif de circuit de bascule (10) selon la revendication 1, dans lequel les aimants (151, 15r) sont disposés, chacun, sur des côtés opposés de l'élément d'actionnement (14) par rapport à l'axe de rotation (18), de sorte que soit réduite, lors de l'actionnement de l'élément d'actionnement (14), une distance (al, ar) entre l'aimant (15l, 15r) et le capteur de champ magnétique associé (13l, 13r), tandis que soit augmentée une distance (al, ar) de l'autre aimant (15l, 15r) par rapport à l'autre capteur de champ magnétique associé (13l, 13r).

3. Dispositif de circuit de bascule (10) selon l'une des revendications précédentes, dans lequel le signal de capteur (s13r, s131) de l'un des capteurs de champ magnétique (13l) augmente au fur et à mesure qu'augmente la distance (ar) entre l'autre capteur de champ magnétique (13r) et l'aimant associé (15r), et dans lequel le signal de l'autre capteur de champ magnétique (13r) diminue au fur et mesure qu'augmente la distance (ar) entre l'autre capteur de champ magnétique (13r) et l'autre aimant associé (15r).

4. Dispositif de circuit de bascule (10) selon la revendication 3, dans lequel une évolution de signal pour les deux capteurs de champ magnétique (13l, 13r) sur la distance (al, ar) entre le capteur de champ magnétique (13l, 13r) et l'aimant associé (15l, 15r) et entre l'autre capteur de champ magnétique (131, 13r) et l'autre aimant associé (15l, 15r) est non linéaire.

5. Dispositif de circuit de bascule (10) selon l'une des revendications 1 à 4, dans lequel le signal de combinaison présente, sur la plage de déplacement de l'élément d'actionnement (14) par rapport au boîtier (12), une évolution non linéaire.

6. Dispositif de circuit de bascule (10) selon l'une des revendications 1 à 5, dans lequel la plage de valeurs de validité est définie par une enveloppe qui enveloppe une évolution du signal de combinaison sur la plage de déplacement de l'élément d'actionnement (14) par rapport au boîtier (12).

7. Dispositif de circuit de bascule (10) selon la revendication 6, dans lequel une largeur de l'enveloppe est fonction des tolérances de fabrication mécaniques du dispositif de circuit de bascule (10).

8. Dispositif de circuit de bascule (10) selon l'une des revendications précédentes, dans lequel est disposé, entre le boîtier (12) et l'élément d'actionnement (14), un élément de rappel qui est réalisé pour déplacer l'élément d'actionnement (14) par rapport au boîtier (12) dans la position neutre dans laquelle une distance (al, ar) entre un élément capteur et l'aimant associé (15l, 15r) est égale à une distance (al, ar) entre l'autre élément capteur et l'aimant lui associé avec un écart de ± 15%.

9. Dispositif de circuit de bascule (10) selon l'une des revendications précédentes, dans lequel l'élément d'actionnement (14) est déplaçable par rapport au boîtier (12) autour d'un deuxième axe de rotation (18) et présente deux autres aimants (151), et
dans lequel sont couplés de marnière stationnaire à ou dans la plaque de base (11) au moins deux autres capteurs de champ magnétique (13l, 13r) opposés aux autres aimants (151) qui émettent, chacun, un signal de capteur (s13r, s13l) en fonction d'une distance (al, ar) entre le capteur de champ magnétique respectif (13l, 13r) et l'aimant associé (15l, 15r).

10. Unité de commande et de manipulation pour une plate-forme de travail aérienne, une machine de travail mobile ou une machine de construction avec un dispositif de circuit de bascule (10) selon l'une des revendications précédentes.

11. Procédé permettant de faire fonctionner un dispositif de circuit de bascule (10) comportant un boîtier (12), un élément d'actionnement (14) fixé au boîtier (12) et une plaque de base (11), et où l'élément d'actionnement (14) est déplaçable par rapport au boîtier (12) autour d'au moins un axe de rotation (18) et présente au moins deux aimants (15l, 15r), où le boîtier (12) est fixé à la plaque de base (11) et où à ou dans la plaque de base (11) sont couplés de manière stationnaire au moins deux capteurs de champ magnétique (13l, 13r) opposés aux aimants (15l, 15r) qui émettent, chacun, un signal de capteur (s13r, s131) en fonction d'une distance (al, ar) entre le capteur de champ magnétique respectif (13l, 13r) et l'aimant associé (15l, 15r),
**caractérisé par** le fait de
évaluer un signal de combinaison des deux signaux de capteur (s13r, s131) pour déterminer, à partir du signal de combinaison, une position et/ou un déplacement de l'élément d'actionnement, où le signal de combinaison est formé, par position dans la plage de déplacement de l'élément d'actionnement (14) par rapport au boîtier (12), par une paire de valeurs qui comprend les deux signaux de capteur (s13r, s13l);
dans lequel l'évaluation comprend une comparaison du signal de combinaison avec une plage de valeurs de validité qui représente une plage de fonctionnement normal des éléments capteurs, dans lequel la position et/ou le déplacement de l'élément. d'actionnement (14) n'est déterminé que lorsque le signal de combinaison se situe dans la plage de valeurs de validité;
dans lequel l'évaluation comprend une reconnaissance d'une erreur sous forme d'une champ magnétique extérieur ou d'une erreur sous forme d'un défaut de l'un des éléments capteurs, d'un dépassement de la plage de températures et/ou d'une défaut mécanique à l'aide du signal de combinaison, où une erreur est présente lorsque le signal de combinaison se situe en-dehors de la plage de valeurs de validité;
dans lequel le champ magnétique extérieur est reconnu lorsque les deux signaux de capteur (s13r, s131) se situent en-dehors de la plage de valeurs de validité définie par une enveloppe (17), et/ou dans lequel le défaut de l'un des éléments capteurs ou le défaut mécanique est reconnu lorsque la fonction du signal de combinaison ne peut pas être représentée sur toute la plage de déplacement.

12. Programme d'ordinateur pour réaliser le procédé selon la revendication 11 lorsque le programme est exécuté sur l'ordinateur.
